## Europäisches Patentamt

## European Patent Office

## Office européen des brevets

(19)

(11) Veröffentlichungsnummer: **0 032 691**
**B1**

(12) **EUROPÄISCHE PATENTSCHRIFT**

(45) Veröffentlichungstag der Patentschrift:
**20.07.83**

(51) Int. Cl.³: **H 01 L 39/24**

(21) Anmeldenummer: **81100124.7**

(22) Anmeldetag: **09.01.81**

(54) **Verfahren zur Herstellung eines Supraleiters mit einer intermetallischen Verbindung.**

(30) Priorität: **22.01.80 DE 3002196**
**22.01.80 DE 3002177**

(43) Veröffentlichungstag der Anmeldung:
**29.07.81 Patentblatt 81/30**

(45) Bekanntmachung des Hinweises auf die Patenterteilung:
**20.07.83 Patentblatt 83/29**

(84) Benannte Vertragsstaaten:
**CH FR GB IT LI**

(56) Entgegenhaltungen:
**DE-A-1 945 642**
**FR-A-2 293 800**
**US-A-4 053 976**

(73) Patentinhaber: **SIEMENS AKTIENGESELLSCHAFT,**
**Berlin und München Wittelsbacherplatz 2,**
**D-8000 München 2 (DE)**

(72) Erfinder: **Wilhelm, Manfred, Dr., Teutonenstrasse 23,**
**D-8500 Nürnberg (DE)**

## Verfahren zur Herstellung eines Supraleiters mit einer intermetallischen Verbindung

Die Erfindung bezieht sich auf ein Verfahren zur Herstellung eines Supraleiters mit einer supraleitenden intermetallischen Verbindung aus wenigstens zwei Elementen, bei dem ein Leitervorprodukt mit einer ersten, ein Element der Verbindung enthaltenden Komponente und mit einer zweiten Komponente, die aus einer ein Trägermetall und das restliche Element bzw. die restlichen Elemente der Verbindung enthaltenden Legierung gebildet ist, erstellt wird und bei dem das Leitervorprodukt einer solchen Wärmebehandlung unterzogen wird, dass die Verbindung durch Reaktion des Elementes der ersten Komponenten mit dem restlichen Element bzw. den restlichen Elementen der zweiten Komponente gebildet wird. Ein derartiges Herstellungsverfahren eines Supraleiters ist aus der DE-A Nr. 2056779 bekannt.

Aus zwei Komponenten mit jeweils einem Element bestehende supraleitende intermetallische Verbindungen, wie beispielsweise $Nb_3Sn$ oder $V_3Ga$, die vom Typ $A_3B$ sind und A15-Kristallstruktur besitzen, haben sehr gute Supraleitungseigenschaften und zeichnen sich insbesondere durch eine hohe kritische Flussdichte $B_{c2}$ eines Magnetfeldes, eine hohe Sprungtemperatur $T_c$ und eine hohe kritische Stromdichte $I_c$ aus. Sie eignen sich deshalb besonders als Leiter für Supraleitungsspulen zum Erzeugen starker Magnetfelder. Darüber hinaus sind auch Ternärverbindungen wie beispielsweise Niob/Aluminium/Germanium $Nb_3(Al_xGe_{(1-x)})$ von besonderem Interesse. Da diese Verbindungen im allgemeinen sehr spröde sind, ist jedoch ihre Herstellung in einer beispielsweise für Magnetspulen geeigneten Form schwierig. Aus der genannten DE-A Nr. 2056779 ist ein Verfahren bekannt, das eine Herstellung von Supraleitern mit intermetallischen Verbindungen aus zwei Komponenten in Form langer Drähte oder Bänder ermöglicht. Dieses Verfahren dient insbesondere zur Herstellung von sogenannten Vielkernleitern mit in einer normalleitenden Matrix angeordneten Drähten, beispielsweise aus $Nb_3Sn$ oder $V_3Ga$, oder mit Niob- bzw. Vanadiumdrähten mit Oberflächenschichten aus den genannten Verbindungen. Dabei wird ein drahtförmiges duktiles Element der herzustellenden Verbindung, beispielsweise ein Niob- oder ein Vanadiumdraht, mit einer Hülle aus einem duktilen Matrixmaterial, das eine vorbestimmte Menge der übrigen Elemente in Form einer Legierung enthält, beispielsweise einer Zinn- oder Galliumbronze, umgeben. Es kann auch eine Vielzahl solcher Drähte in die Matrix eingelagert werden. Der so gewonnene Aufbau wird dann einer querschnittsverringernden Bearbeitung unterzogen und in eine vorbestimmte Anzahl von Teilstücken zerschnitten. Diese Teilstücke werden dann gebündelt und wiederum durch eine Querschnittsverminderung in eine langgestreckte Form gebracht. Mit den Querschnittsverminderungen wird der Durchmesser der beispielsweise aus Niob oder Vanadium bestehenden Drahtkerne auf einen niedrigen Wert in der Grössenordnung von 10 µm oder weniger reduziert, was im Hinblick auf die Supraleitungseigenschaften des Leiters von Vorteil ist. Ferner wird mit diesem Verfahrensschritt eine gute metallurgische Verbindung zwischen den Drahtkernen und dem sie umgebenden Matrixmaterial erreicht, ohne dass jedoch Reaktionen auftreten, die den Leiter verspröden würden. Man erhält so ein noch nicht durchreagiertes Vorprodukt des Supraleiters in Form eines langen Drahtes, wie er später zum Wickeln von Spulen benötigt wird. Dieses Vorprodukt wird schliesslich einer Glühbehandlung unter Vakuum oder in der Atmosphäre eines inerten Gases wie z.B. Argon unterzogen, wobei das oder die in der Matrix enthaltenen Elemente der zu bildenden supraleitenden Verbindung in das aus dem anderen Element der Verbindung bestehende Material der Drahtkerne eindiffundieren und so mit diesem unter Bildung einer aus der gewünschten supraleitenden Verbindung bestehenden Schicht reagieren.

Es ist wiederholt versucht worden, die Stromtragfähigkeit solcher Vielkernleiter durch besondere Legierungszusätze zu erhöhen. So wurden dem Kernmaterial Niob z.B. kleine Mengen von Tantal zugesetzt [,,IEEE Trans. Magnetics, MAG-14'', Nr. 5 (Sept. 1978), S. 611 bis 613]. Ferner ist auch bekannt, einer Bronzematrix kleine Mengen von Gallium zuzusetzen [,,J. Appl. Phys.'', 49 (1) (Jan. 1978), S. 357 bis 360]. Mit diesen Massnahmen ist zwar eine Steigerung der kritischen Stromdichte der supraleitenden $Nb_3Sn$-Schichten, insbesondere in Magnetfeldern mit Flussdichten oberhalb von 10 T, erreichbar. Durch diese Zusätze wird jedoch im allgemeinen die Verarbeitbarkeit der einen oder anderen Leiterkomponente, insbesondere aufgrund von Legierungsaushärtung, erschwert.

Aufgabe der vorliegenden Erfindung ist es deshalb, das eingangs genannte Verfahren dahingehend zu verbessern, dass eine Anhebung der kritischen Ströme und damit der effektiven Stromdichte der Supraleiter in Magnetfeldern oberhalb 10 T Flussdichte erhalten wird, ohne dass dabei die Verarbeitbarkeit der Leiterkomponenten beeinträchtigt wird.

Eine erste Lösung dieser Aufgabe besteht erfindungsgemäss darin, dass die Wärmebehandlung in einer Wasserstoffatmosphäre vorgenommen wird.

Die Vorteile dieses Verfahrensschrittes bestehen insbesondere darin, dass durch das Glühen in Wasserstoff anstelle von Argon oder Vakuum die effektive Stromdichte der entstandenen Schichten aus den supraleitenden intermetallischen Verbindungen in Magnetfeldern mit Flussdichten oberhalb von 10 T ansteigen. Dieser überraschende Effekt ist festzustellen, wenn die Diffusionsglühung ausschliesslich unter Wasserstoff erfolgt. Vergleicht man die Dotierung mit Wasserstoff mit der bekannten Dotierung durch metallische Zusätze, so ist die Wasserstoffdotierung wesentlich einfacher durchzuführen, da weder das Kernmaterial noch die Leitermatrix vor der Verarbeitung modifiziert werden müssen.

Eine weitere Lösung der genannten Aufgabe besteht erfindungsgemäss darin, dass nach der Wärmebehandlung zur Bildung der supraleitenden Verbindung eine thermische Nachbehandlung in einer Wasserstoffatmosphäre vorgenommen wird.

Es ist zwar aus der FR-A Nr. 2293800 bekannt, bei Supraleitern zweiter Art zur Verankerung der Flussfäden sich neben anderen Methoden — wie Neutronenbestrahlung, Dotierung mit metallischen Verunreinigungen oder Wärmebehandlung bei hohen Temperaturen — auch der Dotierung mit gasförmigen Verunreinigungen zu bedienen (S. 1, Zeile 17). Jedoch gibt die Druckschrift keine Hinweise, welche Gasarten hierfür in Frage kommen könnten.

Weiterhin ist aus dieser Druckschrift bekannt, einen auf einen Träger mittels eines Plasmabrenners aufgesputterten Supraleiter einer anschliessenden Wärmebehandlung in einer Wasserstoffatmosphäre zu unterziehen. Jedoch hat diese Wärmebehandlung in einer Wasserstoffatmosphäre den Sinn, während des Aufsputterns gebildete Metalloxide zu Metallen chemisch zu reduzieren. Eine solche chemische Reduktion spielt bei dem vorliegenden Verfahren keine Rolle.

Die beim vorliegenden Verfahren mit einer Wärmebehandlung in Wasserstoffatmosphäre erreichten Vorteile bestehen insbesondere darin, dass die effektive Stromdichte der so hergestellten Schichten aus den supraleitenden intermetallischen Verbindungen insbesondere in Magnetfeldern mit Flussdichten oberhalb von 10 T ansteigt. Dieser überraschende Effekt stellt sich dann ein, wenn die Supraleiter nach der üblichen Glühung unter beispielsweise Argon kurzzeitig unter Wasserstoff nachgeglüht werden. Vergleicht man die Dotierung mit Wasserstoff mit der bekannten Dotierung durch metallische Zusätze, so ist die Wasserstoffdotierung wesentlich einfacher durchzuführen, da weder das Kernmaterial noch die Leitermatrix vor der Verarbeitung modifiziert werden müssen. Ausserdem kann sogar daran gedacht werden, dass Magnetspulen, die mit in Argon geglühten Supraleitern bereits gewickelt worden sind, einer Nachglühung in Wasserstoff unterworfen werden, um so die Stromtragfähigkeit ihrer Leiter noch zu erhöhen.

Zur weiteren Erläuterung der beiden Verfahren gemäss der Erfindung und deren in den Unteransprüchen gekennzeichneten Ausbildungen wird nachfolgend auf die Ausführungsbeispiele und die angegebenen Tabellen Bezug genommen.

Den Ausführungsbeispielen ist ein Herstellungsverfahren von Drahtproben eines Nb$_3$Sn-Multifilamentleiters mit 10 000 Filamenten und einem Gesamtdurchmesser von 0,5 mm zugrundegelegt, dessen supraleitende Bereiche mit Hilfe der bekannten Bronzetechnik durch Feststoffdiffusion gebildet werden (vgl. die DE-OS Nr. 2052323).

*Ausführungsbeispiel I*

Zu Vergleichszwecken wurde ein entsprechendes Leitervorprodukt einer allgemein bekannten Standardglühung bei 700° C in einer Argonatmosphäre von 0,5 bar etwa 64 h lang unterzogen.

*Ausführungsbeispiel II*

Im Gegensatz zu der Glühung des Leitervorproduktes entsprechend dem Ausführungsbeispiel I wurden gemäss der Erfindung zwei Leitervorprodukte etwa 64 h lang bei 700° C statt in einer Argonatmosphäre in einer Wasserstoffatmosphäre von etwa 0,3 bar geglüht.

Die sich bei den gemäss den vorstehenden Ausführungsbeispielen I und II ergebenden kritischen Ströme $I_c$ und effektiven Stromdichten $J_{eff}$ sind in der folgenden Tabelle in Abhängigkeit von auf sie einwirkenden Magnetfeldern mit Flussdichten B oberhalb von 10 T wiedergegeben. Dabei ist $J_{eff}$ $=I_c/F$, wobei F die Querschnittsfläche des Leiters ist.

Die kritischen Ströme $I_c$ sind in Ampere und die effektiven Stromdichten $J_{eff}$ in $10^{-5}$ A/cm$^2$ angegeben.

*Tabelle I*

| Ausführungsbeispiel Nr. | B [T] | 10 | 11 | 12 | 15 |
|---|---|---|---|---|---|
| I | | Standardglühung 64h/700°C (0,5bar Ar) | | | |
| | $I_c$: | 171 | 135 | 108 | 45 |
| | $J_{eff}$: | 0,87 | 0,69 | 0,55 | 0,23 |
| II | | 64h/700°C (0,3bar H$_2$) | | | |
| | Leiter 1: $I_c$: | 164 | 135 | 111 | 57 |
| | $J_{eff}$: | 0,84 | 0,69 | 0,57 | 0,29 |
| | Leiter 2: $I_c$: | 167 | 138 | 113 | 57,7 |
| | $J_{eff}$: | 0,85 | 0,70 | 0,58 | 0,29 |

Wie der vorstehenden Tabelle zu entnehmen ist, beträgt der mit den Massnahmen gemäss der Erfindung zu verzeichnende Gewinn an effektiver Stromdichte etwa 4 bis 6% bei Flussdichten von 12 T und etwa 26% bei 15 T.

Ferner wurde festgestellt, dass die mit den Massnahmen gemäss der Erfindung erreichbaren Werte der kritischen Stromstärke $I_c$ und der effektiven Stromdichte $J_{eff}$ im allgemeinen erst bei Flussdichten oberhalb von 10 T gegenüber den Werten der in Argon oder unter Vakuum geglühten Leiter erhöht sind. Die nach dem ersten Verfahren gemäss der Erfindung hergestellten Leiter werden somit vorteilhaft insbesondere für supraleitende Einrichtungen wie Magnetspulen vorgesehen, bei denen sie Magnetfeldern mit Flussdichten oberhalb 10 T ausgesetzt werden.

Bei der Herstellung der Leiter gemäss der Erfindung, wie sie dem Ausführungsbeispiel II zu-

grundegelegt wurde, ist davon ausgegangen, dass die Wärmebehandlung in der Wasserstoffatmosphäre aus einem einzigen Behandlungsschritt bei einer vorbestimmten Temperatur besteht. Gegebenenfalls können jedoch auch mehrere Behandlungsschritte bei verschiedenen Temperaturen in der Wasserstoffatmosphäre vorgenommen werden. Ferner wurde ein Druck von etwa 0,3 bar angenommen. Zur Anhebung der kritischen Stromstärke $I_c$ oberhalb 10 T genügen jedoch auch geringere Drücke. Im allgemeinen sollte jedoch der Druck der Wasserstoffatmosphäre mindestens $10^{-3}$ bar betragen.

Im allgemeinen ist ein Gewinn an effektiver Stromdichte gegenüber den gemäss dem Ausführungsbeispiel I behandelten Supraleitern dann zu erhalten, wenn eine Temperatur von mindestens 600, vorzugsweise von etwa 700° C, gewählt wird, wobei bei den tieferen Temperaturen im allgemeinen längere Glühzeiten als bei den hohen Temperaturen vorzusehen sind.

Gemäss dem im Ausführungsbeispiel II angedeuteten ersten Verfahren nach der Erfindung wurde die Wärmebehandlung der Leitervorprodukte zur Ausbildung der supraleitenden intermetallischen Verbindung in einer Wasserstoffatmosphäre vorgenommen, um den kritischen Strom und die effektive Stromdichte zu erhöhen. Dieses Ziel kann jedoch gemäss der weiteren Erfindung auch dadurch erreicht werden, dass man erst nach der Wärmebehandlung zur Bildung der supraleitenden Verbindung eine thermische Nachbehandlung in einer Wasserstoffatmosphäre vornimmt. Entsprechende Verfahrensschritte sind in den nachfolgenden Ausführungsbeispielen III bis VII angedeutet.

*Ausführungsbeispiele III bis VI*

Entsprechend dem Ausführungsbeispiel I hergestellte supraleitende $Nb_3Sn$-Diffusionsleiter wurden gemäss der Erfindung zusätzlich einer Nachglühung in einer Wasserstoffatmosphäre von etwa 0,3 bar bei 700° C unterzogen, wobei in der Wasserstoffatmosphäre gemäss Ausführungsbeispiel III etwa 64 h, gemäss Ausführungsbeispiel IV etwa 8 h, gemäss Ausführungsbeispiel V etwa 4 h und gemäss Ausführungsbeispiel VI etwa 2 h lang geglüht wurde.

Die sich bei den gemäss den vorstehenden Ausführungsbeispielen III und IV ergebenden kritischen Ströme $I_c$ und effektiven Stromdichten $J_{eff}$ sind in der folgenden Tabelle II in Abhängigkeit von auf sie einwirkenden Magnetfeldern mit Flussdichten B oberhalb von 10 T wiedergegeben, wobei zu Vergleichszwecken die entsprechenden Werte aus Ausführungsbeispiel I ebenfalls enthalten sind. Dabei ist $J_{eff}=I_c/F$, wobei F die Querschnittsfläche des Leiters ist. Die kritischen Ströme $I_c$ sind in Ampere und die effektiven Stromdichten $J_{eff}$ in $10^{-5}$ A/cm² angegeben

Tabelle →

Wie der vorstehenden Tabelle zu entnehmen ist, beträgt der mit den Massnahmen gemäss der Erfindung zu verzeichnende Gewinn an effektiver

→ *Tabelle II*

| Ausführungsbeispiel Nr. | B [T] | 10 | 11 | 12 | 15 |
|---|---|---|---|---|---|
| I | | Standardglühung 64h/700°C (0,5bar Ar) | | | |
| | $I_c$: | 171 | 135 | 108 | 45 |
| | $J_{eff}$: | 0,87 | 0,69 | 0,55 | 0,23 |
| III | | 64h/700°C (0,5bar Ar) + 64h/700°C (0,3bar $H_2$) | | | |
| | $I_c$: | 170 | 140 | 115 | 60 |
| | $J_{eff}$: | 0,87 | 0,71 | 0,59 | 0,31 |
| IV | | 64h/700°C (0,5bar Ar) + 8h/700°C (0,3bar $H_2$) | | | |
| | $I_c$: | 174 | 144 | 118 | 61 |
| | $J_{eff}$: | 0,89 | 0,73 | 0,60 | 0,31 |
| V | | 64h/700°C (0,5bar Ar) + 4h/700°C (0,3bar $H_2$) | | | |
| | $I_c$: | 173 | 143 | 117 | 59 |
| | $J_{eff}$: | 0,88 | 0,73 | 0,60 | 0,30 |
| VI | | 64h/700°C (0,5bar Ar) +2h/700°C (0,3bar $H_2$) | | | |
| | $I_c$: | 174 | 144 | 118 | 59 |
| | $J_{eff}$: | 0,89 | 0,73 | 0,60 | 0,30 |

Stromdichte etwa bis zu 9% bei Flussdichten von 12 T und etwa bis zu 35% bei 15 T.

Ferner wurde festgestellt, dass die mit den Massnahmen gemäss der Erfindung erreichbaren Werte der kritischen Stromstärke $I_c$ und der effektiven Stromdichte $J_{eff}$ im allgemeinen erst bei Flussdichten oberhalb von 10 T gegenüber den Werten der nur in Argon oder unter Vakuum geglühten Leiter erhöht sind. Die nach dem Verfahren gemäss der Erfindung hergestellten Leiter werden somit vorteilhaft insbesondere für supraleitende Einrichtungen wie Magnetspulen vorgesehen, bei denen sie Magnetfeldern mit Flussdichten oberhalb 10 T ausgesetzt werden.

Bei der Herstellung der Leiter gemäss der Erfindung, wie sie den Ausführungsbeispielen III bis VI zugrundegelegt wurde, ist davon ausgegangen, dass der Druck der Wasserstoffatmosphäre bei etwa 0,3 bar liegt. Es können jedoch auch geringere Drücke vorgesehen werden. Im allgemeinen genügt es nämlich zur Anhebung der kritischen Stromstärke $I_c$ oberhalb von 10 T, dass der Druck der Wasserstoffatmosphäre mindestens etwa $10^{-3}$ bar beträgt. Ausserdem wurde angenommen, dass die Wärmebehandlung in der Wasserstoffatmosphäre aus einem einzigen Behandlungsschritt bei einer vorbestimmten Temperatur besteht. Gegebenenfalls können jedoch auch mehrere Behandlungsschritte bei verschiedenen Temperaturen in der Wasserstoffatmosphäre vorgenommen werden. Die Temperaturabhängigkeit wurde gemäss dem nachfolgenden Ausführungsbeispiel untersucht.

*Ausführungsbeispiel VII*

Das Leitervorprodukt eines $Nb_3Sn$-Multifilamentleiters wurde gemäss dem Ausführungsbeispiel I zunächst 64 h lang bei 700° C unter Argon geglüht, um die supraleitende intermetallische Verbindung $Nb_3Sn$ zu bilden. Anschliessend wurden verschiedene Nachglühungen unter Wasserstoffatmosphäre bei 0,3 bar vorgenommen, und zwar bei Temperaturen zwischen 300 und 800° C während Zeitdauern zwischen 20 und 1 h. Dabei stellte sich heraus, dass ein Gewinn an effektiver Stromdichte gegenüber den gemäss dem Ausführungsbeispiel I behandelten Supraleitern dann zu erhalten ist, wenn eine Temperatur von über 350° C, vorzugsweise von etwa 400 oder etwa 700° C, gewählt wird, wobei bei den tieferen Temperaturen im allgemeinen längere Glühzeiten als bei den hohen Temperaturen vorzusehen sind.

Gemäss den Ausführungsbeispielen wurde die Herstellung von supraleitenden Multifilamentleitern mit der intermetallischen Verbindung $Nb_3Sn$ angenommen. Das Verfahren nach der Erfindung eignet sich jedoch ebensogut auch zur Herstellung von Supraleitern anderer bekannter intermetallischer Verbindungen mittels Feststoffdiffusion wie z.B. von $V_3Ga$-Leitern.

**Patentansprüche**

1. Verfahren zur Herstellung eines Supraleiters mit einer supraleitenden intermetallischen Verbindung aus wenigstens zwei Elementen, bei dem ein Leitervorprodukt mit einer ersten, ein Element der Verbindung enthaltenden Komponente und mit einer zweiten Komponente, die aus einer ein Trägermetall und das restliche Element bzw. die restlichen Elemente der Verbindung enthaltenden Legierung gebildet ist, erstellt wird und bei dem das Leitervorprodukt einer solchen Wärmebehandlung unterzogen wird, dass die Verbindung durch Reaktion des Elementes der ersten Komponente mit dem restlichen Element bzw. den restlichen Elementen der zweiten Komponente gebildet wird, dadurch gekennzeichnet, dass die Wärmebehandlung in einer Wasserstoffatmosphäre vorgenommen wird.

2. Herstellungsverfahren nach Anspruch 1, gekennzeichnet durch eine Wärmebehandlung bei mindestens 600, vorzugsweise bei etwa 700° C.

3. Herstellungsverfahren nach einem der beiden Ansprüche 1 oder 2, gekennzeichnet durch einen Druck der Wassestoffatmosphäre von mindestens $10^{-3}$ bar.

4. Herstellungsverfahren nach einem der Ansprüche 1 bis 3, gekennzeichnet durch eine Wärmebehandlung mit mindestens zwei Behandlungsschritten bei verschiedenen Temperaturen.

5. Verfahren zur Herstellung eines Supraleiters mit einer supraleitenden intermetallischen Verbindung aus wenigstens zwei Elementen, bei dem ein Leitervorprodukt mit einer ersten, ein Element der Verbindung enthaltenden Komponente und mit einer zweiten Komponente, die aus einer ein Trägermetall und das restliche Element bzw. die restlichen Elemente der Verbindung enthaltenden Legierung gebildet ist, erstellt wird und bei dem das Leitervorprodukt einer solchen Wärmebehandlung unterzogen wird, dass die Verbindung durch Reaktion des Elementes der ersten Komponente mit dem restlichen Element bzw. den restlichen Elementen der zweiten Komponente gebildet wird, dadurch gekennzeichnet, dass nach der Wärmebehandlung zur Bildung der supraleitenden Verbindung eine thermische Nachbehandlung in einer Wasserstoffatmosphäre vorgenommen wird.

6. Herstellungsverfahren nach Anspruch 5, gekennzeichnet durch eine thermische Nachbehandlung in der Wasserstoffatmosphäre bei über 350° C.

7. Herstellungsverfahren nach einem der beiden Ansprüche 5 oder 6, gekennzeichnet durch einen Druck der Wasserstoffatmosphäre von mindestens $10^{-3}$ bar.

8. Herstellungsverfahren nach einem der Ansprüche 5 bis 7, gekennzeichnet durch eine thermische Nachbehandlung in der Wasserstoffatmosphäre mit mindestens zwei Behandlungsschritten bei verschiedenen Temperaturen.

9. Verwendung des Verfahrens gemäss einem der Ansprüche 1 bis 8 zur Herstellung eines Supraleiters für supraleitende Einrichtungen mit Magnetfeldern, deren Flussdichten oberhalb von 10 T liegen.

**Claims**

1. A process for the production of a superconductor having a superconducting intermetallic compound consisting of at least two elements, in which a conductor initial product is produced having a first component which contains one element of the compound and a second component which is formed from an alloy containing a carrier metal and the remaining element or elements of the compound, and in which the conductor initial product is subjected to a heat treatment such that the compound is formed by reaction of the element of the first component with the remaining element or elements of the second component, characterized in that the heat treatment is carried out in a hydrogen atmosphere.

2. A production process as claimed in claim 1, characterized by a heat treatment carried out at at least 600° C, preferably at about 700° C.

3. A production process as claimed in one of claims 1 or 2, characterized by a hydrogen atmosphere pressure of at least $10^{-3}$ bar.

4. A production process as claimed in one of claims 1 to 3, characterized by a heat treatment comprising at least two treatment steps carried out at different temperatures.

5. A process for the production of a superconductor having a superconductive intermetallic compound which consists of at least two elements, in which a conductor initial product is produced having a first component which contains one element of the compound and a second component which is formed from an alloy containing a carrier metal and the remaining element or elements of the compound, and in which the conductor initial product is subjected to a heat treatment such that the compound is formed by reaction of the element of the first component with the remaining element or elements of the second component, characterized in that, after the heat treatment for the formation of the superconductive compound, a thermal after-treatment is carried out in a hydrogen atmosphere.

6. A production process as claimed in claim 5, characterized by a thermal after-treatment carried out in a hydrogen atmosphere at a temperature of above 350° C.

7. A production process as claimed in one of claims 5 or 6, characterized by a hydrogen atmosphere pressure of at least $10^{-3}$ bar.

8. A production process as claimed in one of claims 5 to 7, characterized by a thermal after-treatment in the hydrogen atmosphere comprising at least two treatment steps carried out at different temperatures.

9. The use of the process as claimed in one of claims 1 to 8 for the production of a superconductor for superconductive devices involving magnetic fields whose flux densities are above 10 T.

## Revendications

1. Procédé pour la fabrication d'un supraconducteur avec un composé intermétallique supraconducteur constitué par au moins deux éléments, dans lequel un produit précurseur de conducteur est préparé avec un premier composant contenant un élément du composé et avec un second composant qui est formé par un alliage contenant un métal de support et l'élément restant ou les éléments restants du composé, et dans lequel le produit précurseur de conducteur est soumis à un traitement thermique qui est tel que le composé est formé par la réaction de l'élément du premier composant avec l'élément restant ou les éléments restants du second composant, caractérisé par le fait que le traitement thermique est opéré dans une atmosphère d'hydrogène.

2. Procédé de fabrication selon la revendication 1, caractérisé par un traitement thermique à au moins 600° C, de préférence à environ 700° C.

3. Procédé de fabrication selon l'une des revendications 1 ou 2, caractérisé par une pression de l'atmosphère d'hydrogène d'au moins $10^{-3}$ bar.

4. Procédé de fabrication selon l'une des revendications 1 à 3, caractérisé par un traitement thermique à au moins deux étapes de traitement à des températures différentes.

5. Procédé pour la fabrication d'un supraconducteur avec un composé intermétallique supraconducteur constitué par au moins deux éléments, dans lequel un produit précurseur de conducteur est préparé avec un premier composant contenant un élément de composé et avec un second composant qui est formé par un alliage contenant un métal de support et l'élément restant ou les éléments restants du composé, et dans lequel le produit précurseur de conducteur est soumis à un traitement thermique qui est tel que le composé est formé par la réaction de l'élément du premier composant avec l'élément restant ou les éléments restants du second composant, caractérisé par le fait que, après le traitement thermique pour la formation du composé supraconducteur, on procède à un post-traitement thermique dans une atmosphère d'hydrogène.

6. Procédé de fabrication selon la revendication 5, caractérisé par un post-traitement thermique dans une atmosphère d'hydrogène à plus de 350° C.

7. Procédé de fabrication selon l'une des revendications 5 ou 6, caractérisé par une pression de l'atmosphère d'hydrogène d'au moins $10^{-3}$ bar.

8. Procédé de fabrication selon l'une des revendications 5 à 7, caractérisé par un post-traitement thermique dans une atmosphère d'hydrogène avec au moins deux étapes de traitement à des températures différentes.

9. Mise en œuvre du procédé selon l'une des revendications 1 à 8 pour la fabrication d'un supraconducteur pour des dispositifs supraconducteurs à champ magnétique dont les densités du flux se situent au-dessus de 10 T.